# EUROPEAN PATENT APPLICATION

(11) **EP 4 092 695 A1**
(43) Date of publication of application: **23.11.2022**
(21) Application number: 21174491.7
(22) Date of filing: 18.05.2021
(51) Int. Cl.: H01F 5/00, H01F 41/04, H01F 17/04, H05K 1/16, H01F 17/00

(54) **A MAGNETIC INLAY WITH ELECTRICALLY CONDUCTIVE VERTICAL THROUGH CONNECTIONS FOR A COMPONENT CARRIER**

(71) Applicant: AT & S Austria Technologie & Systemtechnik Aktiengesellschaft, 8700 Leoben-Hinterberg (AT)
(72) Inventor: Salkovic, Ivan, 10020 Zagreb (HR); Nickkholgh, Amin, Theran (IR)
(74) Representative: Dilg, Haeusler, Schindelmann Patentanwaltsgesellschaft mbH

(57) **Abstract**

It is described a magnetic inlay (100) comprising a magnetic matrix (110) and a plurality of electrically conductive vertical through connections (150) extending vertically through the magnetic matrix (110). Further, a component carrier (200) comprising the magnetic inlay (100) and a method of manufacturing said magnetic inlay (100) are described.

## Description

### Field of the Invention

The invention related to a magnetic inlay. The invention further relates to a component carrier that comprises the magnetic inlay. Further, the invention related to a method of manufacturing the magnetic inlay. Accordingly, the invention may relate to the technical field of magnetic/inductive applications in component carriers such as printed circuit boards or IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions. Moreover, an extended functionality of component carriers is demanded by users. For example, it is known to integrate magnetic material in a component carrier in order to provide an inductance for specific applications. However, conventional approaches may suffer from low inductance values and high production costs.

For example, a conventional approach of providing a magnetic inductance for a component carrier may be seen in arranging a magnetic paste in a circuit board, in particular around a plated trough hole of the circuit board. Further, embedding the magnetic paste in the circuit board may be considered cumbersome and not cost-efficient.

### Summary of the Invention

There may be a need to provide a magnetic inductance for a component carrier in an efficient and robust manner.

A magnetic inlay, a component carrier, and a method of manufacturing according to the independent claims are provided.

According to an aspect of the invention, a magnetic inlay (i.e. a separate component that is manufactured independent from the device, to which it should be assembled) is described comprising a magnetic matrix (e.g. a magnetic sheet or a magnetic paste) and a plurality of electrically conductive vertical through connections (e.g. plated or filled with electrically conductive material) extending vertically (i.e. essentially perpendicular to a direction of main extension of the inlay, which would be horizontally) through the magnetic matrix (the term "essentially perpendicular" may refer to an angle between 80° and 90°, in particular 90°).

According to a further aspect of the invention, a component carrier is described, wherein the component carrier comprises:
i) a (layer) stack comprising at least one electrically conductive layer structure and/or at least one electrically insulating layer structure, and
ii) a magnetic inlay, as described above, assembled (inlayed, i.e. surface mounted or embedded) to the stack.

According to a further aspect of the invention, a method of manufacturing a magnetic inlay is described, wherein the method comprises:
i) providing a magnetic matrix, and
ii) forming (e.g. drilling) a plurality of electrically conductive vertical through connections extending vertically through the magnetic matrix.

In the context of the present document, the term "magnetic matrix" may in particular refer to a base material (base substance) that comprises magnetic properties. The base material may be magnetic itself or magnetic particles may be distributed within a non-magnetic matrix material. The magnetic matrix may be configured for example rigid/solid (e.g. as magnetic sheets) or viscous (magnetic paste). The magnetic matrix may comprise electrically conductive material/particles and/or electrically insulating material/particles. Further, the magnetic matrix may be configured to have a relative magnetic permeability µᵣ in a range from 2 to 10⁶, in particular 20 to 80. A plurality of different materials may be considered suitable to provide the base material and/or the embedded particles of the magnetic matrix, for example a ferromagnetic material (like iron), a ferrimagnetic material (like ferrite), a permanent magnetic material, a soft magnetic material, a metal oxide. In an example, a dielectric (resin) matrix with magnetic particles therein is used. In another example, magnetic sheets are applied that comprise magnetic particles embedded in a fiber-enforced resin (e.g. prepreg). In a further example, a magnetic paste is used that comprises magnetic particles embedded in a not fiber-enforced resin. In a further example, the magnetic matrix is arranged in the inlay in a planar manner.

In the context of the present document, the term "electrically conductive vertical through connections" may in particular denote any electrical connections that reaches through (i.e. from a first main surface to a second (opposed) main surface). In a basic form, a hole may be drilled through the magnetic matrix and the sidewalls of the hole may be copper-plated. In a more advanced form, the hole is partially or completely filled with electrically conductive and/or electrically insulating material. At their respective ends (at the main surfaces), the through connections may further comprise pads in order to allow an efficient electric connection, e.g. to horizontal electrically conductive traces.

In the context of the present document, the term "inlay" may refer to a separate component/element that is manufactured in an inlay manufacturing process being independent from the component carrier manufacturing process. The inlay may be configured to be surface mounted on or embedded in said component carrier. However, the inlay may be produced, sold, and shipped completely independent of the component carrier. The inlay may also be termed "inductor component" and may particularly denote a standalone electronic member which provides an inductance in the framework of an electronic application in which the inductor component is implemented. The inlay may be formed on the basis of component carrier technology, in particular on the basis of printed circuit board (PCB) technology, and may be surface-mounted or embedded in a separately formed component carrier such as a PCB. However, the inlay component may also be used in conjunction with non-component carrier applications.

The magnetic inlay may be essentially shaped as a plate, meaning that it comprises two directions of main extension along the x- and y-axes and a comparably short extension along the z-axis. In this context, the term "horizontal" may thus mean "oriented in parallel with a direction of main extension", while the term "vertical" may mean "oriented perpendicular to the directions of main extension". Hence, even if the inlay is turned around, the terms "vertical" and "horizontal" always have the same meaning. Further, the magnetic inlay may comprise different shapes, for example one of circular, rectangular, polygonal. In the context of the present document, the term "via" (vertical interconnection access) may refer to an electrical connection between layers in a physical electronic circuit that goes through the plane of one or more adjacent layers. The term via may include through-hole vias, buried vias, and blind vias. While vias may be used to connect only a few layers (in a stack) with each other, a "plated through hole" may be used to connect all layers of a stack. Microvias are used as interconnects between layers in high density interconnect (HDI) substrates and printed circuit boards (PCBs) to accommodate the high I/O density of advanced packages. In the present document, an electrically conductive through connection may be called a via.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate. A component carrier may also be a hybrid board combining different ones of the above mentioned types of component carriers.

According to an exemplary embodiment, the invention may be based on the idea that a magnetic inductance (magnetically enhanced inductance) for a component carrier can be provided in an efficient and robust manner, when a magnetic inlay is used that comprises a magnetic matrix with electrically conductive vertical through connections.

Conventionally, magnetic paste is provided directly within the component carrier manufacturing process (e.g. by filling additionally drilled holes/cavities in the component carrier with the magnetic paste), which may be cost-intensive and cumbersome.

The inventors have now found that it is surprisingly efficient to provide the magnetic material as a separate inlay for the component carrier instead of forming the magnetic material together with the component carrier. In particular, the inventive inlay already comprises electrically conductive vertical through connections that can be electrically connected to (electrically conductive) layer structures of the component carrier in a feasible and easy manner. Most surprisingly, the inlay, when assembled and electrically connected to the component carrier, enables inductance values of around four times higher than conventional examples. This strong improvement may be particularly achieved by the significantly higher amount of magnetic material (and larger magnetic particles sizes) that can be realized using the inlay, but not in conventional magnetic paste that is directly formed with the component carrier during manufacturing. As an additional advantage, the inlay even allows for a higher density structure (improved line-spacing) and thus an efficient and robust miniaturization.

The significantly improved inductance values may be in particular suitable for specific applications such as power converters, current sensors, transformers, and processors for servers.

### Description of Exemplary Embodiments

According to an embodiment, the plurality of electrically conductive vertical through connections are arranged in a pattern of rows and columns. This may provide the advantage that a specific electric connection array can be obtained. Further, this design may facilitate establishing a coil-like structure through the magnetic inlay.

According to a further embodiment, at least one of the electrically conductive vertical through connections is a through hole filled partially (plated through-hole) or entirely (e.g. completely filled, for example by plating) with a metal, in particular copper. In this manner, a highly electrically conductive and reliable electric connection can be provided. Further, a metal-filled via may be considered more robust and stable than an unfilled via.

According to a further embodiment, at least one of the electrically conductive vertical through connections is a hollow lining which is filled at least partially with an electrically insulating material, in particular a resin. This may provide the advantage that the through connection is more robust/stable and/or can be designed in a flexible manner regarding different functionalities. For example, the through hole may be drilled through the magnetic matrix and then, the sidewalls of the hole are plated with conductive material (e.g. copper). Afterwards, the hollow lining (cavity) can be filled partially or completely with an insulating material, for example resin such as insulator ink. In another embodiment, the hollow lining may be filled with a magnetic material such as magnetic paste.

According to a further embodiment, at least one of the electrically conductive vertical through connections is a circular (cylindrical) through hole filled at least partially with electrically conductive material. Thereby, the through holes of the inlay can be manufactured (e.g. mechanically drilled) using established and standardized PCB methodology such as via formation.

According to a further embodiment, at least one of the electrically conductive vertical through connections is a frustoconical through hole filled at least partially with electrically conductive material. Also in this manner, the through holes of the inlay can be manufactured (e.g. by laser drilling which leads inherently to a hole with tapering sidewalls in the drilling direction) using established and standardized PCB methodology.

According to a further embodiment, the magnetic matrix continuously fills a volume between and around the plurality of electrically conductive vertical through connections. This may provide the advantage that a high amount of magnetic material can be applied, and an accordingly high inductance can be achieved. While conventionally only magnetic paste is arranged in small amounts around vias during component carrier manufacturing (which leads to low inductance values), the described inlay allows for applying a high amount of magnetic matrix (that fills all the space between the vias). This is because the through connections may be directly drilled through the magnetic matrix and no further embedding steps are necessary.

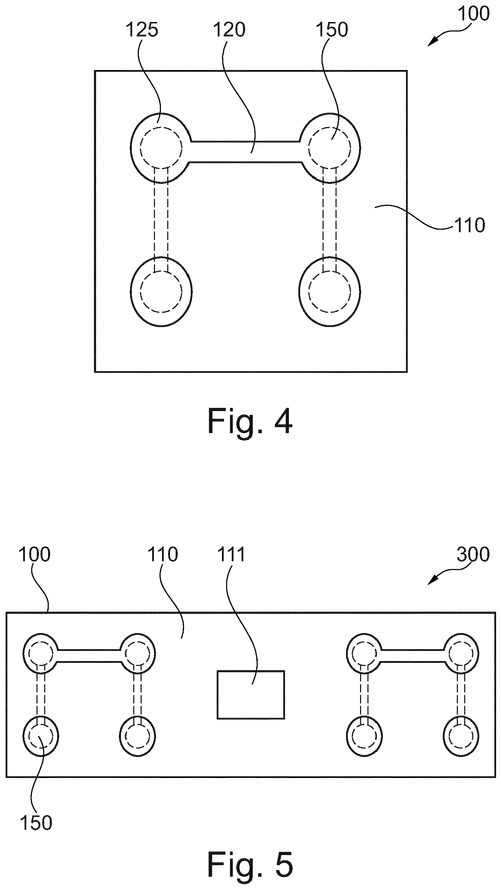

According to a further embodiment, the inlay comprises a hole in the magnetic matrix between a first group and a second group of the plurality of electrically conductive vertical through connections. In this specific configuration (see Figure 5 below), the inlay can be applied as an efficient transformer. The plurality of electrically conductive vertical through connections may hereby be arranged as rows and columns (array) that are interconnected using horizontal traces in order to provide coil-like structures. The hole may be used to insert an iron core as known from transformer technology.

According to a further embodiment, the inlay comprises at least one horizontally extending electrically conductive trace on one of or on both opposing main surfaces of the magnetic matrix. This may provide the specific advantage that the through connections can be electrically connected (inter-/horizontal connection of through connections) in an efficient, yet design-flexible, manner. Further, a coil-like structure may be obtained in this manner using a plurality of vertical through connections electrically connected by the horizontal traces.

According to a further embodiment, the at least one electrically conductive trace and at least one of the electrically conductive vertical through connections are electrically coupled with each other.

According to a further embodiment, the inlay comprises at least one pad electrically coupling the at least one electrically conductive trace and at least one of the electrically conductive vertical through connections. This measure enables an efficient and design-flexible electrical connection between the horizontal trace and an electrically conductive vertical through hole. At a position, where the through hole sticks out of the inlay, the pad can be applied to provide a reliable electric connection (in other words: the pad enables a manufacturing tolerance). Thus, the pads of the through connections (at the upper and/or lower surface of the inlay or component carrier) may be used as connection points for the horizontal traces.

According to a further embodiment, the at least one electrically conductive trace and the at least one of the electrically conductive vertical through connections are connected to form at least one winding, in particular a plurality of windings, more particularly a coil (like structure). Using the traces and pads, as described above, may thus enable the provision of a coil structure. Such a coil may include a plurality of vertical through connections and corresponding traces. The more windings a coil comprises, the higher inductance values may be obtained.

In the context of the present document, the term "winding" may particularly denote a loop structure (which may be similar to a helical structure with corners), wherein multiple of such loops may form a coil-type arrangement. However, due to the component carrier manufacturing technology (for instance involving lamination) of the inlay and/or due to the used component carrier raw materials (for instance involving planar constituents such as plates and foils), the windings of the coil (like) structure may have edge-like or corner-like portions rather than being limited to a composition of multiple interconnected purely circular structures.

According to a further embodiment, the magnetic matrix comprises at least one of the group consisting of a rigid solid, and a paste. Depending on the desired functionality, different configurations of the magnetic matrix may be especially suitable. For example, the magnetic matrix may be configured as a magnetic sheet (rigid) that can be laminated. In this example, the magnetic matrix may comprise a prepreg or another resin with embedded magnetic particles. In another example, the magnetic matrix may be configured as a magnetic paste (viscous) that could be filled/poured in a mold to manufacture the inlay. In a further example, the magnetic matrix may be provided by sintering (e.g. sintered ferrites).

According to a further embodiment, the magnetic matrix comprises one of the group which consists of: electrically conductive, electrically insulating, partially electrically conductive and partially electrically insulating (e.g. a first electrically conductive part and a second electrically insulating part). Depending on the desired functionality, different configurations of the magnetic matrix may be especially suitable.

According to a further embodiment, the relative magnetic permeability µᵣ of the magnetic matrix is in a range from 2 to 10⁶, in particular 2 to 1000, more in particular 20 to 1000, more in particular 20 to 80, more in particular around 50. These values are comparably high and can lead to an advantageously high inductance value. Permeability is the measure of magnetization that a material obtains in response to an applied magnetic field. The relative permeability, denoted by the symbol µᵣ, is the ratio of the permeability of a specific medium µ to the permeability of free space µ₀ (vacuum).

According to a further embodiment, the magnetic matrix comprises at least one material of the group consisting of a ferromagnetic material (e.g. iron, nickel), a ferrimagnetic material, a permanent magnetic material, a soft magnetic material, a ferrite, a metal oxide (e.g. magnetite), a dielectric matrix (e.g. a resin), in particular a prepreg, with magnetic particles therein, and an alloy, in particular an iron alloy or alloyed silicon. Thereby, established materials can be directly applied to manufacture the magnetic matrix in a cost-efficient manner.

A permanent magnetic material may be ferromagnetic material or ferrimagnetic material, and may for instance be provided on the basis of transition metals (with partially filled 3d shell) such as iron or nickel, or on the basis of rare earths (with partially filled 4f shell).

A soft magnetic material may be a material which can be easily re-magnetized, i.e. having a small area of its hysteresis curve. In other words, soft magnetic materials are those materials that are easily magnetized and demagnetized. They may have intrinsic coercivity less than 1000 Am⁻¹.

A ferrite may be denoted as a type of ceramic compound composed of Fe₂O₃ combined chemically with one or more additional metallic elements. Ferrites are both electrically non-conductive and ferrimagnetic, so they can be magnetized or attracted by a magnet. Ferrites may be implemented as hard ferrites or soft ferrites, depending on the application.

According to a further embodiment, the magnetic inlay is embedded in the stack (of the component carrier).

According to a further embodiment, the magnetic inlay is surface mounted on the stack (of the component carrier).

The magnetic inlay may be a separate component compared with the component carrier, and is manufactured in a separate process. Thus, the inlay may be considered as a flexibly usable element (yet a finished product) that can be integrated in the component carrier (not yet a finished product) manufacturing process. Depending on the desired functionality, the inlay can be efficiently embedded in a cavity of the component carrier (e.g. encapsulated in resin such as prepreg) or be surface mounted on a main surface of the component carrier (e.g. using an adhesive). While embedding may be considered as a robust protection of the inlay, surface mounting may facilitate electric connections to the inlay.

According to a further embodiment, the at least one electrically conductive layer structure is electrically coupled with at least one of the electrically conductive vertical through connections. This may provide the advantage that the electrically conductive structures of the inlay can be directly coupled/connected with the electrically conductive structures of the component carrier. While conventionally, through holes of the component carrier had to be equipped in a cumbersome manner with magnetic material, the described inlay enables an easy, yet robust, integration and electrical connection. For example, electrically conductive horizontal traces of the component carrier may be electrically connected to horizontal pads (or traces) of the vertical through connections of the inlay.

According to a further embodiment, the at least one electrically conductive layer structure electrically coupled with at least one of the electrically conductive vertical through connections form a coil structure. Especially advantageously, electrically conductive (layer) structures of the inlay and the component carrier may be combined to provide a (large) coil structure. For example, vertical through connections (vias) of the component carrier may be electrically connected (e.g. by traces and/or pads) to the vertical through connections of the inlay.

According to a further embodiment, the component carrier is configured as one of the group consisting of an inductor, a transformer, a wireless charger, a power converter, a DC/DC converter, an AC/DC inverter, a DC/AC inverter, an AC/AC converter, and a current sensor. Thus, the described magnetic inlay may be flexibly applied in a plurality of industrially important and technically demanding devices that may require inductance properties.

According to a further embodiment, the method comprises forming a plurality of through holes in the magnetic matrix, and at least partially filling the through holes with electrically conductive material.

According to a further embodiment, the method comprises forming at least one through hole by drilling, in particular by laser drilling or mechanically drilling.

In an embodiment, the magnetic inlay may be configured for shielding electromagnetic radiation from propagating within the component carrier or within the stack (for instance from a first portion of the stack to a second portion of the stack). The magnetic inlay may however also be configured for shielding electromagnetic radiation from propagating between component carrier and an environment. Such a shielding may include a prevention of electromagnetic radiation from propagating from an exterior of the component carrier to an interior of the component carrier, from an interior of the component carrier to an exterior of the component carrier, and/or between different portions of the component carrier. In particular, such a shielding may be accomplished in a lateral direction of the stack (i.e. horizontally) and/or in a stacking direction of the stack (i.e. vertically). In such an embodiment, the magnetic inlay may function for shielding electromagnetic radiation to thereby suppress undesired effects of electromagnetic interference (EMI), in particular in the radiofrequency (RF) regime.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a mi-croelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a side view of a component carrier with an embedded magnetic inlay according to an exemplary embodiment of the invention.
Figures 2 to 4 show respective top views of the magnetic inlay according to exemplary embodiments of the invention.
Figure 5 shows a transformer with the magnetic inlay according to an exemplary embodiment of the invention.

### Detailed Description of Exemplary Embodiments

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, a simulation of the magnetic properties i) permeability, ii) inductance value, and ii) inductance density, in relation with each other, has been performed. The results of the simulation are shown in the table below. It can be clearly seen that the high permeability (due to a high amount of magnetic material) that is achieved by the magnetic inlay, results in especially high and advantageous inductance and inductance density values. These are significantly higher than in the conventional approaches.

| | | | | | | | | |
|---|---|---|---|---|---|---|---|---|
| Permeability [µ] | 5 | 10 | 15 | 20 | 25 | 30 | 35 | 40 |
| Inductance [nH] | 6.41 | 11.2 | 16.1 | 20.8 | 25.6 | 30.5 | 35.3 | 40.1 |
| Inductance density [nH/mm²] | 11.24 | 19.64 | 28.23 | 36.47 | 44.88 | 53.47 | 61.89 | 70.3 |

According to an exemplary embodiment, magnetic particle sizes in the magnetic inlay are bigger (which means more magnetic material as well) than in prior art magnetic material and thus, a higher permeability is achieved. A higher inductance in turn enables a higher output efficiency.

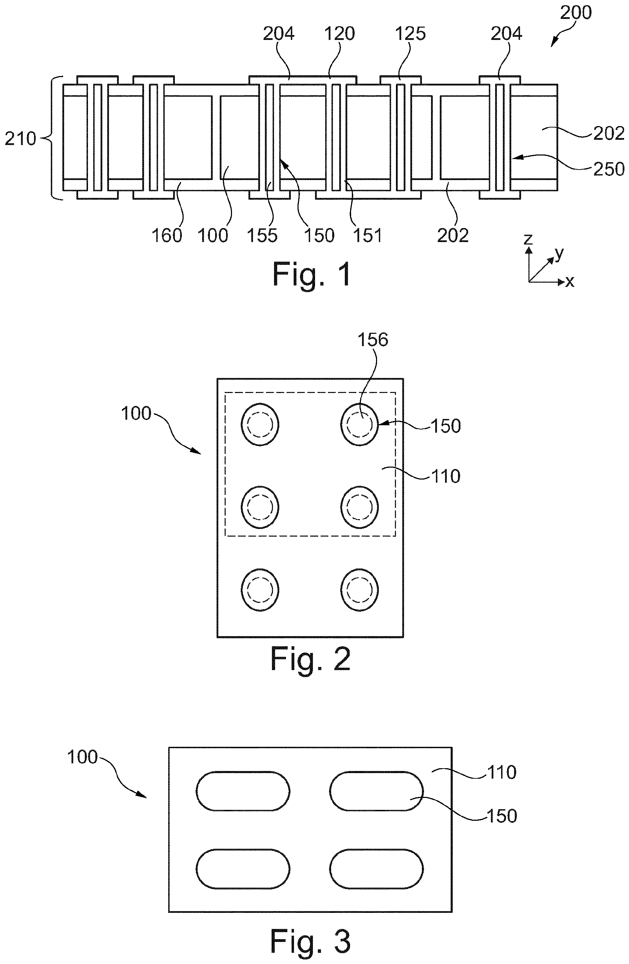

**Figure 1** shows a component carrier 200 according to an exemplary embodiment of the invention. The component carrier 200 comprises a layer stack 210 with electrically conductive layer structures 204 and electrically insulating layer structures 202. The center of the component carrier 200 constitutes an insulating core structure 202 (e.g. fully cured resin such as FR4) that is covered above and below by insulating resin (prepreg) layers 160. Electrically conductive through connections 250 in the form of vias extend through the core structure 202 and the resin layers 160 to thereby electrically connect a first (top) main surface with an opposite second (bottom) main surface of the component carrier 200. In this example, the vias 250 are implemented as copper-plated through holes filled with an insulating material (e.g. resin). On the top side and of the bottom side, respectively, the vias 250 comprise a pad structure 204 to enable an easy electric connection.

The magnetic inlay 100 is embedded in the central core structure 202 of the component carrier 200 and is surrounded by the resin material 160. The magnetic inlay 100 can be placed into a (pre-manufactured) cavity in the core structure 202 of the component carrier 200 and can then be embedded (encapsulated) using the resin material 160, e.g. in form of a prepreg. Alternatively, the magnetic inlay 100 can already be surrounded by the resin material 160 and can then be placed in this manner into the cavity. An adhesive resin may be used in order to stick the magnetic inlay to the cavity sidewalls.

The magnetic inlay 100 comprises a magnetic matrix 110, being a massive magnetic structure with preferably large magnetic particles. This enables an especially high inductance with a relative magnetic permeability µᵣ in a range from 20 to 10⁶.

Vertical through connections have been already drilled through the magnetic inlay 100 and have been plated with copper in order to provide the electrically conductive through connections 150. In the example shown, the electrically conductive through connections 150 are filled with insulating material 155 (e.g. a resin). Each electrically conductive through connection 150 comprises a horizontally extending electrically conductive trace 120 on one of the opposing main surfaces of the magnetic inlay 100/the component carrier 200. The electrically conductive traces 120 and the electrically conductive vertical through connections 150 are hereby electrically coupled with each other. The inlay 100 further comprising pads 125 that electrically couple the electrically conductive traces 120 and the electrically conductive vertical through connections 150. The electrically conductive traces 120 and the electrically conductive vertical through connections 150 are connected in order to form a plurality of windings. Such a coil-like structure provides an advantageous inductance value.

Further, the electrically conductive traces may also be electrically conductive layer structures 204 of the component carrier 200 that are electrically coupled with the electrically conductive vertical through connections 150 of the magnetic inlay 100 to thereby form the coil structure.

The component carrier 200 and the magnetic inlay 100, respectively, comprise an extension of main direction along the x-axis. A further extension of main direction is along the y-axis but cannot be seen in this 2D image. An orientation parallel to these extensions of main direction (e.g. the layer stack 210) is considered as being horizontal. Perpendicular to the main directions, there is a height extension along the z-axis. An orientation parallel to the height direction (e.g. the vias 250 and the electrically conductive vertical through connections 150) is considered as being vertical.

**Figure 2** shows a top view of the magnetic inlay 100 according to an exemplary embodiment of the invention. It can be seen that the plurality of electrically conductive vertical through connections 150 are arranged in a pattern of rows and columns. The magnetic matrix 110 continuously fills a volume between and around the plurality of electrically conductive vertical through connections 150. Further, in this example, the electrically conductive vertical through connections 150 are completely filled with electrically conductive material (copper) 156.

**Figure 3** shows a top view of the magnetic inlay 100 according to a further exemplary embodiment of the invention. In this example, the electrically conductive vertical through connections 150 are provided as a plurality of holes (e.g. five holes) in an essentially oval form, i.e. as slits.

**Figure 4** shows a top view of the magnetic inlay 100 according to a further exemplary embodiment of the invention. In this example, two electrically conductive vertical through connections 150 are electrically conductively connected by an electrically conductive trace 120 arranged on a first main surface of the magnetic inlay 100. These electrically conductive vertical through connections 150 can be further electrically connected to additional vertical through connections 150 by further traces on a second main surface of the magnetic inlay 100, being opposed to the first main surface (shown as dotted lines).

**Figure 5** shows a transformer 300 with the magnetic inlay 100 according to an exemplary embodiment of the invention. The magnetic inlay 100 comprises a hole 111 in the center and the structure of Figure 4 arranged at the sides of the hole 111, respectively. In other words, the hole 111 in the magnetic matrix 110 is situated between a first group and a second group of the plurality of electrically conductive vertical through connections 150. Because electrically conductive traced 120 and electrically conductive vertical through connections 150 are connected, respectively, to form a plurality of windings, transformer coils can be obtained for proving an efficient transformer device.

### Reference signs

- 100: Magnetic inlay
- 110: Magnetic matrix
- 120: Electrically conductive trace
- 125: Pad
- 150: Electrically conductive vertical through connection
- 151: Metal, copper
- 155: Electrically insulating material
- 156: Electrically conductive material
- 160: Resin layer, prepreg
- 200: Component carrier
- 202: Electrically insulating layer structure
- 204: Electrically conductive layer structure
- 210: Stack
- 250: Component carrier via
- 300: Transformer

## Claims

1. A magnetic inlay (100) comprising a magnetic matrix (110) and a plurality of electrically conductive vertical through connections (150) extending vertically through the magnetic matrix (110).

2. The magnetic inlay (100) according to claim 1, wherein the plurality of electrically conductive vertical through connections (150) are arranged in a pattern of rows and columns.

3. The magnetic inlay (100) according to claim 1 or 2, wherein at least one of the electrically conductive vertical through connections (150) is a through hole filled partially or entirely with a metal, in particular copper (156).

4. The magnetic inlay (100) according to any of claims 1 to 3, wherein at least one of the electrically conductive vertical through connections (150) is a hollow lining which is filled at least partially with an electrically insulating material (155), in particular a resin.

5. The magnetic inlay (100) according to any of claims 1 to 4, wherein at least one of the electrically conductive vertical through connections (150) is a circular cylindrical through hole filled at least partially with electrically conductive material (156); or
wherein at least one of the electrically conductive vertical through connections (150) is a frustoconical through hole filled at least partially with electrically conductive material (156).

6. The magnetic inlay (100) according to any of claims 1 to 5, wherein the magnetic matrix (110) continuously fills a volume between and around the plurality of electrically conductive vertical through connections (150).

7. The magnetic inlay (100) according to any of claims 1 to 6, comprising a hole (111) in the magnetic matrix (110) between a first group and a second group of the plurality of electrically conductive vertical through connections (150).

8. The magnetic inlay (100) according to any of claims 1 to 7, comprising at least one horizontally extending electrically conductive trace (120) on one of or on both opposing main surfaces of the magnetic matrix (110),
in particular wherein the at least one electrically conductive trace (120) and at least one of the electrically conductive vertical through connections (150) are electrically coupled with each other,
more in particular wherein the magnetic inlay (100) comprises at least one pad (125) electrically coupling the at least one electrically conductive trace (120) and at least one of the electrically conductive vertical through connections (150).

9. The magnetic inlay (100) according to claim 8, wherein the at least one electrically conductive trace (120) and the at least one of the electrically conductive vertical through connections (150) are connected to form at least one winding, in particular a plurality of windings, more particularly a coil.

10. The magnetic inlay (100) according to any of claims 1 to 9, wherein the magnetic matrix (110) comprises at least one of the following features:
the magnetic matrix (110) comprises at least one of the group consisting of a rigid solid, and a paste;
the magnetic matrix (110) comprises one of the group which consists of:
electrically conductive, electrically insulating, partially electrically conductive and partially electrically insulating;
the relative magnetic permeability µᵣ of the magnetic matrix (110) is in a range from 2 to 10⁶, in particular 20 to 80;
the magnetic matrix (110) comprises at least one material of the group consisting of a ferromagnetic material, a ferrimagnetic material, a permanent magnetic material, a soft magnetic material, a ferrite, a metal oxide, a dielectric matrix, in particular a prepreg, with magnetic particles therein, and an alloy, in particular an iron alloy or alloyed silicon.

11. A component carrier (200), wherein the component carrier (200) comprises:
a stack (210) comprising at least one electrically conductive layer structure (204) and/or at least one electrically insulating layer structure (202); and
a magnetic inlay (100) according to any of claims 1 to 10 assembled to the stack (210).

12. The component carrier (200) according to claim 11,
wherein the magnetic inlay (100) is embedded in the stack (210); or wherein the magnetic inlay (100) is surface mounted on the stack (210).

13. The component carrier (200) according to claim 11 or 12, wherein the component carrier (200) comprises at least one of the following features:
wherein the at least one electrically conductive layer structure (204) is electrically coupled with at least one of the electrically conductive vertical through connections (150);
wherein the at least one electrically conductive layer structure (204) electrically coupled with at least one of the electrically conductive vertical through connections (150) form a coil structure;
wherein the component carrier is configured as one of the group consisting of an inductor, a transformer (300), a wireless charger, a power converter, a DC/DC converter, an AC/DC inverter, a DC/AC inverter, an AC/AC converter, and a current sensor.

14. A method of manufacturing a magnetic inlay (100), wherein the method comprises:
providing a magnetic matrix (110);
forming a plurality of electrically conductive vertical through connections (150) extending vertically through the magnetic matrix (110).

15. The method according to claim 14, wherein the method comprises forming a plurality of through holes in the magnetic matrix (110), and at least partially filling the through holes with electrically conductive material (156),
in particular wherein the method comprises forming at least one through hole by drilling, in particular by laser drilling or mechanically drilling.
